# EUROPEAN PATENT APPLICATION

(11) **EP 2 535 727 A1**
(43) Date of publication of application: **19.12.2012**
(21) Application number: 11739789.3
(22) Date of filing: 02.02.2011
(51) Int. Cl.: G01R 11/00, G01R 22/00, H02J 3/38, H02J 13/00

(54) **ENERGY DISPLAY SYSTEM**

(30) Priority: 08.02.2010 JP 2010025407
(71) Applicant: Toyota Jidosha Kabushiki Kaisha, Toyota-shi, Aichi 471-8571 (JP); Misawa Homes Co., Ltd., Tokyo 163-0833 (JP)
(72) Inventor: OZAKI, Daijiro, Tokyo 168-0072 (JP)
(74) Representative: Goddar, Heinz J.
(86) International application number: PCT/JP2011/052160
(87) International publication number: WO 2011/096441

(57) **Abstract**

The present invention provides an energy display system, comprising a first electric power detection device 11 that can detect the power consumption of grid power, a second electric power detection device 12 that can detect the power consumption of electric power generated by a solar electric power generation device 2, third electric power detection devices 15 and 17 that can detect the power consumption of household electric loads on the basis of grid power and generated power respectively, a fourth electric power detection device 16 that can detect the power consumption resulting from charging of a traveling object 4 on the basis of grid power and generated power respectively, and a display device 7 that is connected with the first through fourth electric power detection devices and can display the power consumption detected by those electric power detection devices; hence, the power consumption due to the household electric loads and power consumption resulting from charging of the traveling object can be displayed on the basis of grid power and generated power respectively.

## Description

### Field of the Invention

The present invention relates to an energy display system that can display the power consumption of household electric loads and the power consumption due to charging of traveling objects on the basis of the grid power and generated power respectively.

### Background of the Invention

Usually, household electric loads used in the home, such as refrigerators, washing machines, air conditioners, or other household electric appliances, etc., operate with AC electric power supply (grid power) from an electric utility company. Since the electric utility company claims for the electricity fee on the basis of the consumption (usage) of electric power, the consumption (usage) of electric power and corresponding electricity fee can be ascertained from the bill.

In recent years, the problem of global warming became extremely urgent, and the emission of carbon dioxide (CO₂) in the refining process of electric power that is used as the energy source became a major cause for global warming. However, at present, the awareness of emission of carbon dioxide in the refining process of electric power consumed for household purpose is still very low among ordinary demanders.

Hence, as an example of display system that displays the data including the power consumption by household electric loads such as electric appliances, etc. and the emission amount of carbon dioxide from generation of the power consumption, etc., the apparatus disclosed in patent document 1 is known to ordinary demanders.

The display system comprises: a plurality of electric appliance groups, each of which operates with commercial AC power supply and has electric power consumption detection devices respectively; a calculation device, which calculates the electricity fee or the emission amount of carbon dioxide produced in the production process of the power consumption in real time according to the power consumption of the electric appliances which is output from the electric appliance groups or preset reference data; and, a display device, which displays the calculation result of the calculation device.

With such a display system, the user can ascertain the data of power consumption of each electric appliance and the data of emission amount of carbon dioxide produced in the production process of the power consumption on the display device. As a result, the system is helpful for enhancing the user's awareness of energy conservation and reducing unnecessary or excessive electric power consumption, and thereby attains the object of energy conservation.

### Earlier technical literatures

Patent documents:
Patent document 1: Patent Publication No. JP2002-40065

### Summary of the Invention

In recent years, in-house electric power generation devices (e.g., solar electric power generation devices, etc.) were utilized to supply power to household electric loads in homes. However, since traditional display systems can't display the electric quantity consumed by power generation in the electric power consumption of household electric loads, it is difficult to ascertain the exact level of reduction of electric power by electric power generation.

In addition, in recent years, electric power operated vehicles such as plug-in hybrid vehicles (PHVs) and electric vehicles (EVs), etc. were developed, and some products have been introduced into the market. For such electric power operated vehicles (traveling objects), it is required to know the power consumption resulting from charging of the traveling objects on the basis of grid power and generated power when they are charged in homes.

In view of above problems, the object of the present invention is to provide an energy display system, which can display the power consumption of household electric loads and power consumption resulting from charging of traveling objects on the basis of the grid power and generated power respectively.

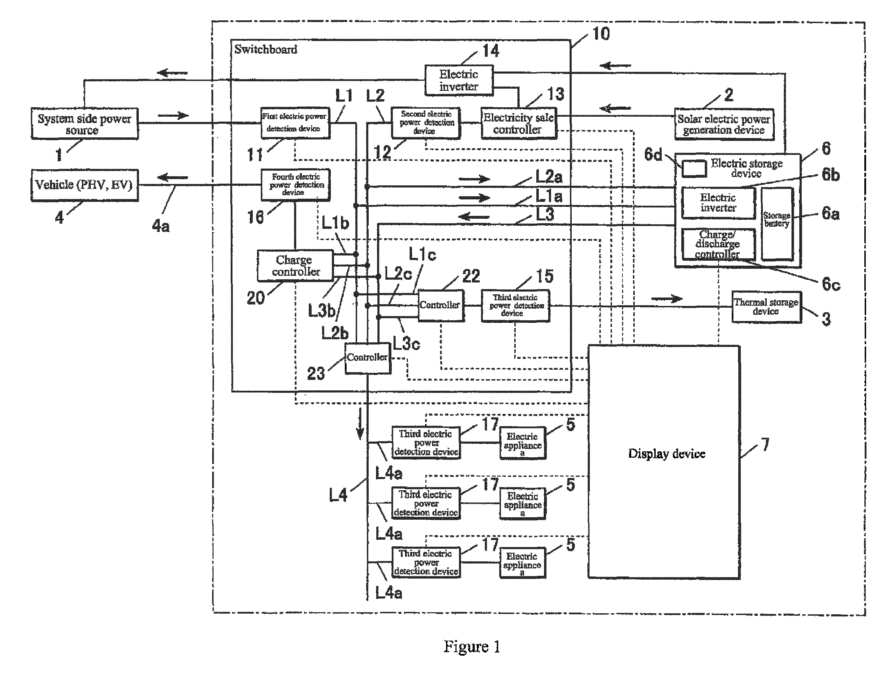

To solve above problems, as shown in Figure 1∼3, the invention described in claim 1 comprises: a first electric power detection device 11, which can detect the power consumption of external grid power;
a second electric power detection device 12, which can detect the power consumption of electric power generated by an in-house power generation device (solar electric power generation devices) 2 that is installed at the side of house and utilizes natural energy to generate electric power;
third electric power detection devices 15 and 17, which can detect the power consumption of household electric loads on the basis of the grid power and generated power respectively;
a fourth electric power detection device 16, which can detect the power consumption resulting from charging of a traveling object 4 on the basis of the grid power and generated power; and a display device 7, which is connected with the first through fourth electric power detection devices, and can display the power consumption detected by the first through fourth electric power detection devices.

The invention described in claim 1, characterized in that: the power consumption of external grid power is detected by the first electric power detection device 11 and displayed on the display device 7; the power consumption of electric power generated by the in-house power generation device (solar electric power generation device) 2 is detected by the second electric power detection device 12 and displayed on the display device 7; the power consumption of household electric loads is detected by the third electric power detection devices 15 and 17 on the basis of the grid power and generated power and displayed on the display device 7; the power consumption resulting from charging of the traveling object 4 is detected by the fourth electric power detection device 16 on the basis of the grid power and generated power and displayed on the display device 7; thus, the power consumption of household electric loads 3 and 5 and the power consumption resulting from charging of the traveling object 4 can be displayed on the basis of the grid power and generated power respectively.

The invention described in claim 2, characterized in that: in the energy display system described in claim 1, the display device 7 comprises a carbon dioxide emission calculation device 31, which calculates the emission amount of carbon dioxide from generation of electric quantity equivalent to the power consumption of grid power detected by the first electric power detection device 11, and can display the calculated emission amount of carbon dioxide.

In the invention described in claim 2, the carbon dioxide emission calculation device 31 calculates the emission amount of carbon dioxide from generation of electric quantity equivalent to the power consumption of grid power detected by the first electric power detection device 11. Thus, the calculated emission amount of carbon dioxide can be displayed on the display device 7.

The invention described in claim 3, characterized in that: in the energy display system described in claim 2, the carbon dioxide emission calculation device 31 can calculate the emission amount of carbon dioxide from generation of electric quantity equivalent to the power consumption of grid power resulting from the household electric loads 3 and 5 and the emission amount of carbon dioxide from generation of electric quantity equivalent to the power consumption of grid power resulting from charging of the traveling object 4, respectively;

The display device 7 can display the two types of calculated emission amount of carbon dioxide.

In the invention described in claim 3, the carbon dioxide emission calculation device 31 calculates the emission amount of carbon dioxide from generation of electric quantity equivalent to the power consumption of grid power resulting from the household electric loads 3 and 5 and the emission amount of carbon dioxide from generation of electric quantity equivalent to the power consumption of grid power resulting from charging of the traveling object 4, respectively. Thus, the two types of calculated emission amount of carbon dioxide can be displayed on the display device 7.

The invention described in claim 4, characterized in that: in the energy display system described in claim 3, the carbon dioxide emission calculation device 31 can calculate the accumulative total emission amount of carbon dioxide from generation of electric quantity equivalent to the power consumption of grid power resulting from charging of the traveling object 4;

The display device 7 can display the calculated accumulative total emission amount of carbon dioxide.

In the invention described in claim 4, the carbon dioxide emission calculation device 31 calculates the accumulative total emission amount of carbon dioxide from generation of the electric quantity equivalent to the power consumption of grid power resulting from charging of the traveling object 4. Thus, the calculated accumulative total emission amount of carbon dioxide can be displayed on the display device 7.

The invention described in claim 5, characterized in that: the energy display system described in any one of claims 1-4 comprises an electricity fee calculation device 32, which calculates the electricity fee caused by charging of the traveling object 4 on the basis of the power consumption of grid power resulting from charging of the traveling object 4; and
a travel distance calculation device 33, which calculates the travel distance for which the traveling object 4 can move, on the basis of the power consumption resulting from charging of the traveling object 4;
the display device 7 can display the calculated electricity fee and travel distance.

In the invention described in claim 5, the electricity fee calculation device 32 calculates the electricity fee caused by charging of the traveling object 4 on the basis of the power consumption of grid power resulting from charging of the traveling object 4; in addition, the travel distance calculation device 33 calculates the travel distance for which the traveling object 4 can move on the basis of the power consumption resulting from charging of the traveling object 4. Thus, the electricity fee caused by charging of the traveling object 4 and the travel distance for which the traveling object 14 can move can be displayed on the display device 7.

The invention described in claim 6, characterized in that: in the energy display system described in claim 5,

The electricity fee calculation device 32 can calculate the accumulative total electricity fee caused by charging of the traveling object 4;

The travel distance calculation device 33 can calculate the accumulative total travel distance in which the traveling object 4 is used normally;

The display device 7 can display the calculated accumulative total electricity fee and accumulative total travel distance.

In the invention described in claim 6, the electricity fee calculation device 32 calculates the accumulative total electricity fee caused by charging of the traveling object 4, and the travel distance calculation device 33 calculates the accumulative total travel distance of the traveling object 4. Thus, the calculated accumulative total electricity fee and accumulative total travel distance can be displayed on the display device 7.

The invention described in claim 7, characterized in that: in the energy display system described in any one of the claims 1-6,
the system comprises: a charge controller 20, which can select the grid power or the electric power generated by the in-house electric power generation device (solar electric power generation device) 2 as the electric power for charging of the traveling object 4;
the charge controller 20 is connected to the display device 7 and can be operated via the display device 7.

In the invention described in claim 7, the charge controller 20 is operated via the display device 7 to select the grid power or the generated power as the electric power for charging of the traveling object 4.

In the present invention, the power consumption of the household electric loads is detected by the third electric power detection device on the basis of grid power and generated power and displayed on the display device, the power consumption resulting from charging of the traveling object is detected by the fourth electric power detection device on the basis of grid power and generated power and displayed on the display device, so that the power consumption of the household electric loads and the power consumption resulting from charging of the traveling object can be displayed on the basis of grid power and generated power respectively.

### Brief Description of the Drawings

Figure 1 is a schematic structural block diagram of an example of the energy display system disclosed in the present invention.
Figure 2 is a schematic structural diagram of the switchboard.
Figure 3 is a schematic structural block diagram of the display device.

### Brief Description of the Symbols

1. System side Power source
2. Solar electric power generation device (in-house electric power generation device)
3. Thermal storage device (household electric load)
4. Traveling object
5. Electric appliance (household electric load)
6. Electrical storage device
7. Display device
11. First electric power detection device
12. Second electric power detection device
15, 17. Third electric power detection device
16. Fourth electric power detection device
31. Carbon dioxide emission calculation device
32. Electricity fee calculation device
33. Travel distance calculation device

### Detailed Description of the Embodiments

Hereunder the energy display system disclosed in the present invention will be described in embodiments, with reference to the accompanying drawings.

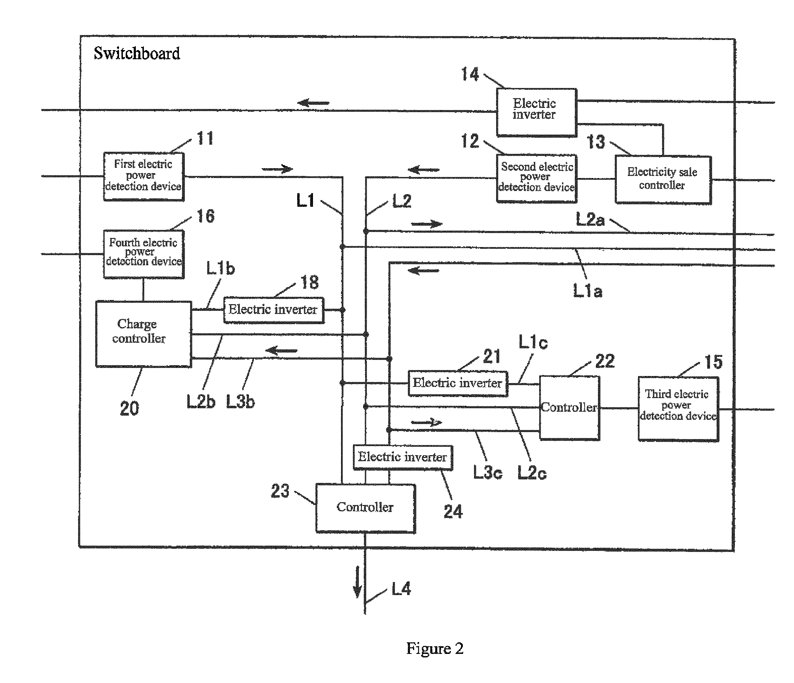

Figure 1 is a schematic structural block diagram of the energy display system disclosed in the present invention; Figure 2 is a schematic structural diagram of the switchboard shown in the block diagram in Figure 1.

The energy display system according to the embodiment comprises: system side power source 1, designed to supply external grid power; a solar electric power generation device 2, installed at the house side and used as an in-housed electric power generation device that utilizes natural energy to generate electric power; a thermal storage device (household electric load) 3, an electric power operated vehicle (traveling object) 4, such as a plug-in hybrid vehicle (PHV) or electric vehicle (EV), etc.; electric appliances (household electric loads) 5 ···arranged at the house side; a electric storage device 6; and a display device 7, etc..

The system side Power source 1 supplies power from an electric utility company and it is connected to a first electric power detection device 11 arranged on a switchboard 10. The power consumption of external grid power can be detected by the first electric power detection device 11 The first electric power detection device 11 is connected to the display device 7, and the power consumption of grid power detected by the first electric power detection device 11 is displayed on the screen of the display device 7.

The solar electric power generation device 2 is an in-house electric power generation device that converts solar energy into DC electric power directly, and it is connected to the second electric power detection device 12 arranged on the switchboard 10. The power consumption of generated electric power of the solar electric power generation device 2 can be detected by the second electric power detection device 12. The second electric power detection device 12 is connected to the display device 7, and the power consumption of generated electric power detected by the second electric power detection device 12 is displayed on the display screen of the display device 7.

In addition, there is an electricity sale controller 13 between the solar electric power generation device 2 and the second electric power detection device 12, and the solar electric power generation device 2 is connected to the second electric power detection device 12 via the electricity sale controller 13.

The electricity sale controller 13 has a function of selling the electric power generated by the solar electric power generation device 2 to the electric utility company via the system side Power source 1. The electricity sale controller 13 is connected to the display device 7, and can be operated on the display device 7. The electricity sale controller 13 can be operated on the display device 7 to sell the surplus electric power generated by the solar electric power generation device 2. The electricity sale controller 13 has a built-in electricity meter, which can detect the sold electric quantity; the sold electric quantity detected by the electricity meter is displayed on the display screen of the display device 7, and at the same time, the after-mentioned electricity fee calculation device 32 arranged on the display device 7 calculates the electricity fee, and the electricity fee is displayed on the display device 7.

In addition, owing to the fact that the electric power generated by the solar electric power generation device 2 is DC electric power, the generated electric power is converted into AC electric power by an electric inverter 14 before it is sold.

The thermal storage device (household electric load) 3 (e.g., an electric heater that utilizes thermal pump technique to boil up water with the thermal energy of air) is connected to the third electric power detection device 15 arranged on the switchboard 10. The third electric power detection device 15 is connected to the display device 7, and the power consumption of the thermal storage device 3 detected by the third electric power detection device 15 is displayed on the display screen of the display device 7.

In addition, the thermal storage device 3 drives an electric motor for the thermal pump with DC electric power.

As described above, the traveling object 4 is electric power operated vehicle, such as a power hybrid vehicle (PHV) or electric vehicle (EV), etc., which has a rechargeable storage battery (battery) that is not shown. In addition, the traveling object 4 is not limited to four-wheel vehicles, which is to say, it can also be a two-wheel motorcycle or motor scooter.

The storage battery of the traveling object 4 is connected with a charging cable 4a in a removable manner, and the charging cable 4a is connected to the fourth electric power detection device 16. The fourth electric power detection device 16 is connected to the display device 7, and the power consumption resulting from charging of the traveling object 4 detected by the fourth electric power detection device 16 is displayed on the display screen of the display device 7.

The electric appliances (household electric loads) 5 ··· are household electric appliance arranged in the home, such as refrigerator, washing machine, air conditioner, TV set, and electric lamp, etc., and they are connected to the third electric power detection device 17 respectively. The third electric power detection device 17 is connected to the display device 7, and the power consumption of the electric appliances 5 detected by the third electric power detection device 17 is displayed on the display screen of the display device 7.

Moreover, in this embodiment, the third electric power detection device 17 is not arranged on the switchboard 10 directly; but it is connected to the electric appliances 5 and then connected to the switchboard 10; however, it can arranged on the switchboard 10 alternatively.

The electrical storage device 6 is designed to store the surplus electric power generated by the solar electric power generation device 2 and the grid power that is cheaper during nocturnal time, and can discharge as required. The electrical storage device 6 comprises a storage battery 6a composed of Li-ion cells, etc., an electric inverter 6b, and a charge/discharge controller 6c. The electric inverter 6b is an inverter that converts AC grid power to DC electric power, and is controlled by the charge/discharge controller 6c. Moreover, the charge/discharge controller 6c controls the charge/discharge of the storage battery 6a, and thereby stores the DC electric power converted by the electric inverter 6b from the grid power in the storage battery 6a or store the DC electric power generated by the solar electric power generation device 2 in the storage battery 6a, and discharge the electric power stored in the storage battery 6a as required. In addition, the discharged electric power is supplied to the traveling object 4, thermal storage device 3, and electric appliances 5, etc. The charge/discharge controller 6c is connected to the display device 7, and can be operated on the screen of the display device 7. For example, the charge/discharge controller 6c can be instructed to charge/discharge by operating and setting on the screen of the display device 7. When the charge/discharge controller 6c is instructed to charge/discharge, the operation mode, start time of charge/discharge, end time of charge/discharge, and electric power priority during charging, etc., can be set on the screen of the display device 7.

In addition, the electric power priority during charging refers to the precedence in which the grid power (system side Power source 1) or generated electric power (solar electric power generation device 2) is used as the electric power for charging first.

As shown in Figure 1 and Figure 2, wiring L1 for supply of grid power from the system side Power source 1, wiring L2 for supply of generated power from the solar electric power generation device 2, and wiring L3 for supply of stored power from the electrical storage device 6 are arranged in the switchboard 10.

The wiring L1 is for supply of AC power; wiring L1a is branched from wiring L1 and is connected to the electrical storage device 6, to supply AC power to the electrical storage device 6. In the electrical storage device 6, AC power is converted into DC power by the electric inverter 6b and stored in storage battery 6a. During power storage, the storage battery 6a and electric inverter 6b are controlled appropriately by the charge/discharge controller 6c. Moreover, the electrical storage device 6 has a built-in electricity meter 6d, and the stored electric quantity detected by the electricity meter 6d is displayed on the display screen of the display device 7. In addition, the electricity meter 6d can detect the electric quantity discharged from the storage battery 6, and the discharged electric quantity is displayed on the display screen of the display device 7.

In addition, wiring L1b is branched from the wiring L1, and is connected to the charge controller 20 via an electric inverter 18. The electric inverter 18 is an inverter that converts AC electric power to DC electric power.

The charge controller 20 is a controller that controls the DC power supplied for charging the storage battery of the traveling object 4, and it is connected to the display device 7 and can be operated on the display device 7. For example, the charge controller 20 can be instructed to charge by operating and setting on the screen of the display device 7. When the charge controller 20 is instructed to charge, the operation mode, start time of charge, end time of charge, and priority of utilized electric power, etc., can be set on the screen of the display device 7.

In addition, the priority of utilized electric power refers to the precedence in which the grid power (system side Power source 1), generated electric power (solar electric power generation device 2), or stored electric power (electrical storage device 6) is used as the utilized electric power first.

Moreover, automatic mode and manual mode are available for the operation mode. When automatic mode is selected, the charge controller 20 operates automatically, and charge the storage battery on the traveling object 4 according to the preset start time of charge, end time of charge, and priority of utilized electric power, etc.. When manual mode is selected, the grid power (system side Power source 1), generated electric power (solar electric power generation device 2), or stored electric power (electrical storage device 6) can be selected to charge the storage battery.

In addition, wiring L1c is branched from the wiring L1, and is connected to a controller 22 via an electric inverter 21. The electric inverter 21 is an inverter that converts AC electric power to DC electric power.

The controller 22 is a controller that controls the DC power supply to the thermal storage device 3, and it is connected to the display device 7 and can be operated on the display device 7. For example, the controller 22 can be instructed to supply power by operating and setting on the screen of the display device 7. When the controller 22 is instructed to supply power, the operation mode, start time of power supply, end time of power supply, and priority of utilized electric power, etc., can be set on the screen of the display device 7.

In addition, the priority of utilized electric power refers to the precedence in which the grid power (system side Power source 1), generated electric power (solar electric power generation device 2), or stored electric power (electrical storage device 6) is used as the utilized electric power first.

Moreover, automatic mode and manual mode are available for the operation mode. When automatic mode is selected, the controller 22 operates automatically, and supplies power to the thermal storage device 3 according to the preset start time of charge, end time of charge, and priority of utilized electric power, etc.. When manual mode is selected, the grid power (system side Power source 1), generated electric power (solar electric power generation device 2), or stored electric power (electrical storage device 6) can be selected to supply power to the thermal storage device 3.

The wiring L2 is for supply of DC electric power; wiring L2a is branched from the wiring L2, and is connected to the electrical storage device 6 to supply DC electric power to the electrical storage device 6. In the electrical storage device 6, the DC electric power is stored in the storage battery 6a; during electric power storage, the storage battery 6a and electric inverter 6b are controlled appropriately by the charge/discharge controller 6c.

In addition, wiring L2b is branched from the wiring L2, and is connected to the charge controller 20.

In addition, wiring L2c is branched from the wiring L2, and is connected to the controller 22. The wiring L3 is the wiring for supply of DC power; wiring L3b is branched from the wiring L3, and is connected to the charge controller 20.

In addition, wiring L3c is branched from the wiring L3, and is connected to the controller 22. The wiring L1 is directly connected to a controller 23 and the wiring L2 and L2 are connected to the controller 23 via the electric inverter 24 respectively.

The electric inverter 24 is an inverter that converts AC electric power to DC electric power. The controller 23 is connected to the wiring L4. Wiring L4 is the wiring for supply of AC power from the switchboard 10 to the electric appliances (household electric appliances) 5; wirings L4a ··· are branched from the wiring L4 and are connected to the electric appliances 5 via the third electric power detection device 17.

In addition, the controller 23 is a controller that controls AC power supply through the wiring L4, the AC power is AC power supplied by the wiring L1, AC power converted by the electric inverter 24 from the DC power supplied by the wiring L2, and AC power converted by the electric inverter 24 from the DC power supplied by the wiring L3; the controller 23 is connected to the display device 7, and can be operated on the display device 7. For example, the controller 23 can be instructed to supply power by operating and setting on the screen of the display device 7. When the controller 22 is instructed to supply power, the operation mode, start time of power supply, end time of power supply, and priority of utilized electric power, etc., can be set on the screen of the display device 7.

In addition, the priority of utilized electric power refers to the precedence in which the grid power (system side Power source 1), generated electric power (solar electric power generation device 2), or stored electric power (electrical storage device 6) is used as the utilized electric power first.

Moreover, automatic mode and manual mode are available for the operation mode. When automatic mode is selected, the controller 23 operates automatically, and supplies power through the wiring L4 according to the preset start time of charge, end time of charge, and priority of utilized electric power, etc.. When manual mode is selected, the grid power (system side Power source 1), generated electric power (solar electric power generation device 2), or stored electric power (electrical storage device 6) can be selected to supply power through the wiring L4.

The third electric power detection device 17 can detect the power consumption of the electric appliances (household electric loads) 5 according to the grid power, generated power, and stored power.

That is to say, since the wiring L1 for supply of grid power, wiring L2 for supply of generated power, and wiring L3 for supply of stored power are connected to the controller 23 respectively, the power consumption of the electric appliances (household electric loads) 5 can be detected by the third electric power detection device 17 according to the grid power, generated power, and stored power, by controlling the electric power supplied through the wiring L4 with the controller 23 appropriately.

Similar to the third electric power detection device 17, the third electric power detection device 15 can also detect the power consumption of the thermal storage device (household electric load) 3 according to the grid power, generated power, and stored power.

That is to say, since the wiring L1 for supply of grid power, wiring L2 for supply of generated power, and wiring L3 for supply of stored power are connected to the controller 22 respectively, the power consumption of the thermal storage device (household electric load) 3 can be detected by the third electric power detection device 15 according to the grid power, generated power, and stored power, by controlling the electric power supplied to the thermal storage device 3 with the controller 22 appropriately.

The fourth electric power detection device 16 can detect the power consumption resulting from charging of the traveling object 4 according to the grid power, generated power, and stored power.

That is to say, since the wiring L1 for supply of grid power, wiring L2 for supply of generated power, and wiring L3 for supply of stored power are connected to the charge controller 20 respectively, the power consumption resulting from charging of the traveling object 4 can be detected by the fourth electric power detection device 16 according to the grid power, generated power, and stored power, by controlling the electric power supplied to the traveling object 4 with the charge controller 20 appropriately.

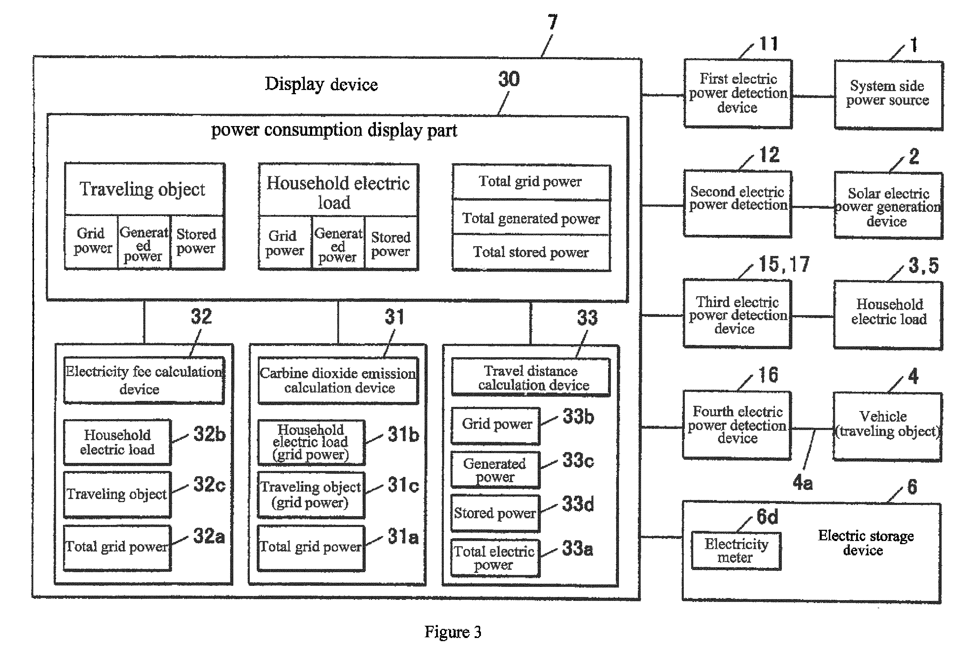

As shown in Figure 3, the display device 7 has a power consumption display part 30. The power consumption display part 30 displays the power consumption of the household electric loads (thermal storage device 3, electric appliances 5) according to the grid power, generated power, and stored power, on the basis of the power consumption detected by the third electric power detection devices 15 and 17 respectively, and displays the power consumption resulting from charging of the traveling object 4 according to the grid power, generated power, and stored power, on the basis of power consumption detected by the fourth electric power detection device 16 respectively.

In addition, the power consumption display part 30 displays the total power consumption of grid power according to the power consumption detected by the first electric power detection device, displays the total power consumption of generated power according to the power consumption detected by the second electric power detection device, and displays the total power consumption of stored power according to the power consumption detected by the built-in electricity meter 6d in the electrical storage device 6.

Moreover, the power consumption is displayed on the power consumption display part 30 on daily, monthly, and annual basis. The power consumption is displayed in figures and diagrams. In addition, in the display device 7, the user can set a target value of power consumption, and display the ratios of actual power consumption to the target value on daily, monthly, and annual basis. In addition, the target value is the maximum value of power consumption, and is set to prevent exceeding that maximum value.

With the power consumption of household electric loads (thermal storage device 3 and electric appliances 5) taken into account, the electricity meter 6d in the electrical storage device 6 detects the level of utilization (charging) of grid power and generated power when the electrical storage device 6 is charged with grid power and generated power. In addition, the detected power consumption is displayed on the power consumption display part 30.

Likewise, with the power consumption resulting from charging of the traveling object 4 taken into account, the electricity meter 6d in the electrical storage device 6 detects the level of utilization (charging) of grid power and generated power when the electrical storage device 6 is charged with grid power and generated power. In addition, the detected power consumption is displayed on the power consumption display part 30.

The display device 7 has a carbon dioxide emission calculation device 31. The carbon dioxide emission calculation device 31 calculates the emission amount of carbon dioxide from generation of electric quantity equivalent to the power consumption of grid power detected by the first electric power detection device 11, and the calculated emission amount of carbon dioxide is displayed on a display part 31a.

In addition, the carbon dioxide emission calculation device 31 calculates the emission amount of carbon dioxide from generation of electric quantity equivalent to the electric quantity of grid power consumed by the household electric loads 3 and 5 detected by the third electric power detection device 15 and 17, and the calculated emission amount of carbon dioxide is displayed on a display part 31b.

In addition, the carbon dioxide emission calculation device 31 calculates the emission amount of carbon dioxide from generation of electric quantity equivalent to power consumption of grid power resulting from charging of the traveling object 4 detected by the fourth electric power detection device 16, and the calculated emission amount of carbon dioxide is displayed on a display part 31c.

Moreover, the emission amount of carbon dioxide is displayed on daily, monthly, and annual basis on the power consumption display part 30. The emission amount of carbon dioxide is displayed in figures and diagrams.

Moreover, in the carbon dioxide emission calculation device 31, the user can set a target value of the emission amount of carbon dioxide, and the ratios of actual emission amount of carbon dioxide to target value are displayed on the display parts 31a, 31b, and 31c on daily, monthly, and annual basis. In addition, the target value is the maximum value of the emission amount of carbon dioxide, and is set to prevent exceeding that maximum value.

The carbon dioxide emission calculation device 31 can calculate the accumulative total emission amount of carbon dioxide from generation of electric quantity equivalent to the total power consumption of grid power, the accumulative total emission amount of carbon dioxide from generation of electric quantity equivalent to the power consumption of grid power resulting from the household electric loads 3 and 5, and the accumulative total emission amount of carbon dioxide from generation of electric quantity equivalent to the power consumption of grid power resulting from charging of the traveling object 4, respectively, and the calculated accumulative total emission amounts of carbon dioxide are displayed on the display part 31a, 31b, and 31c, respectively.

In addition, the carbon dioxide emission calculation device 31 performs calculation by subtracting the emission amount of carbon dioxide from generation of electric quantity equivalent to the power consumption of grid power resulting from charging of the traveling object 4 from the emission amount of carbon dioxide from a gasoline vehicle that has the same power as the traveling object 4. In addition, the calculated value is displayed on a display part, such as the display part 31c.

The display device 7 has an electricity fee calculation device 32. The electricity fee calculation device 32 calculates the electricity fee equivalent to the total power consumption of grid power according to the power consumption of grid power detected by the first electric power detection device 11, and the calculated electricity fee is displayed on a display part 32a.

In addition, the electricity fee calculation device 32 calculates the electricity fee equivalent to the electric quantity of grid power consumed by the household electric loads 3 and 5 detected by the third electric power detection device 15 and 17, and the calculated electricity fee is displayed on the display part 32b.

In addition, the electricity fee calculation device 32 calculates the electricity fee equivalent to the power consumption of grid power resulting from charging of the traveling object 4 detected by the fourth electric power detection device 16, and the calculated electricity fee is displayed on a display part 32c.

In addition, the electricity fee calculation device 32 calculates the electricity fee equivalent to the charged electric quantity detected by the built-in electricity meter in the electricity sale controller 13, and subtracts the electricity fee equivalent to the sold electric quantity from the electricity fee equivalent to the total power consumption of grid power, and the calculated electricity fee is displayed on the display part 32a, when the surplus generated power from the solar electric power generation device 2 is sold.

Moreover, the electricity fees are displayed on the corresponding display part 32a, 32b, and 32c on daily, monthly, and annual basis. The electricity fees are displayed in figures and diagrams.

In addition, in the electricity fee calculation device 32, the user can set a target value of electricity fee, and the ratios of actual electricity fee to target value are displayed on the display part 32a, 32b, and 32c on daily, monthly, and annual basis. In addition, the target value is the maximum value of electricity fee, and is set to prevent exceeding that maximum value.

Moreover, the display device 7 has a suggestion display function for the ratio of actual value/target value of power consumption, ratio of actual value/target value of the emission amount of carbon dioxide, and ratio of actual value/target value of electricity fee. For example, the suggestion display function will prompt the user for energy conservation by means of voice prompt or indicator flashing, etc., once the ratio of actual value to target value reaches or exceeds 90%.

Moreover, the display device 7 has a function for suggesting the priority setting for charging of the electrical storage device 6, charging of the storage battery (battery) of the traveling object 4, and operation of the thermal storage device 3, etc., and thereby the electric power that produces the least emission amount of carbon dioxide can be utilized. The suggestion is provided to the user by means of figures and diagrams on the display screen or voice prompt, etc.. In addition, the user can set the priority in advance on a selection screen of the display device 7.

The display device 7 has a travel distance calculation device 33. The travel distance calculation device 33 calculates the travel distance for which the traveling object 4 can move according to the power consumption resulting from charging of the traveling object 4, and the calculated travel distance is displayed on a display part 33a.

In addition, the travel distance calculation device 33 calculates the travel distance of traveling object 4 equivalent to the power consumption of grid power resulting from charging of the traveling object 4 detected by the fourth electric power detection device 16, and the calculated travel distance is displayed on a display part 33b.

In addition, the travel distance calculation device 33 calculates the travel distance equivalent to the power consumption of generated power resulting from charging of the traveling object 4 detected by the fourth electric power detection device 16, and the calculated travel distance is displayed on a display part 33c.

In addition, the travel distance calculation device 33 calculates the travel distance equivalent to the power consumption of stored power resulting from charging of the traveling object 4 detected by the fourth electric power detection device 16, and the calculated travel distance is displayed on a display part 33d.

When the storage battery (battery) of the traveling object 4 is connected with a charging cable 4a, the travel distance calculation device 33 checks whether any residual electricity remains in the storage battery (battery); if there is residual electricity in the storage battery (battery), the travel distance calculation device 33 detects the residual electric quantity, adds the travel distance equivalent to the residual electric quantity to the travel distance of traveling object 4 calculated on the basis of the electric quantity charged to the traveling object 4, and displays the result on the display part 33a.

Moreover, the travel distance calculation device 33 can calculate the accumulative total travel distance of the traveling object, and display the calculated accumulative total travel distance on the display part 33a.

Here, when the storage battery (battery) of the traveling object 4 is connected with the charging cable 4a, the travel distance calculation device 33 checks whether any residual electricity remains in the storage battery (battery); if there is residual electricity in the storage battery (battery), the travel distance calculation device 33 detects the residual electric quantity, and calculates the accumulative total travel distance of the traveling object 4 by calculating the accumulative total electric quantity charged to the storage battery (battery) of the traveling object 4 in the previous charge cycles and subtracting the residual electric quantity, and the calculated accumulative total travel distance is displayed on the display part 33a. Otherwise, if no residual electricity remains in the storage battery (battery), the travel distance calculation device 33 calculates the accumulative total travel distance of the traveling object by calculating the accumulative total electric quantity charged to the storage battery (battery) of the traveling object 4 in the previous charge cycles, and the calculated accumulative total travel distance is displayed on the display part 33a.

In an energy display system in the structure described above, the power consumption of external grid power is detected by the first electric power detection device 11 and displayed on the display device 7, the power consumption of generated power from the solar electric power generation device 2 is detected by the second electric power detection device 12 and displayed on the display device 7, the power consumption of stored power in the electrical storage device 6 is detected by the electricity meter 6d and displayed on the display device 7, the power consumption of the household electric loads 3 and 5 are detected by the third electric power detection device 15 and 17 on the basis of grid power, generated power, and stored power and displayed on the display device 7, and the power consumption resulting from charging of the traveling object is detected by the fourth electric power detection device 16 on the basis of grid power, generated power, and stored power and displayed on the display device 7; hence, the power consumption of the household electric loads 3 and 5 and the power consumption resulting from charging of the traveling object 4 can be displayed on the basis of grid power, generated power, and stored power respectively.

Moreover, the display device 7 has a carbon dioxide emission calculation device 31, which calculates the emission amount of carbon dioxide from generation of electric quantity equivalent to the power consumption of grid power detected by the first electric power detection device 11; thereby, the calculated emission amount of carbon dioxide can be displayed on the display device 7.

In addition, the carbon dioxide emission calculation device 31 can calculate the emission amount of carbon dioxide from generation of electric quantity equivalent to the power consumption of grid power resulting from the household electric load 3 and 5 and the emission amount of carbon dioxide from generation of electric quantity equivalent to the power consumption of grid power resulting from charging of the traveling object 4 respectively; therefore, the two types of emission amount of carbon dioxide can be displayed on the display device 7.

In addition, the carbon dioxide emission calculation device 31 can calculate the accumulative total emission amount of carbon dioxide from generation of electric quantity equivalent to the power consumption of grid power resulting from charging of the traveling object 4; therefore, the calculated accumulative total emission amount of carbon dioxide can be displayed on the display device 7.

In addition, the energy display system has an electricity fee calculation device 32 that calculates the electricity fee caused by charging of the traveling object 4 according to the power consumption of grid power resulting from charging of the traveling object 4, a travel distance calculation device 33 that calculates the travel distance for which the traveling object 4 can move according to the power consumption resulting from charging of the traveling object 4; therefore, the calculated electricity fee caused by charging of the traveling object 4 and the travel distance of the traveling object 4 can be displayed on the display device 7.

In addition, the electricity fee calculation device 32 can calculate the accumulative total electricity fee caused by charging of the traveling object 4 and the accumulative total travel distance of the traveling object 4; therefore, the calculated accumulative total electricity fee and accumulative total travel distance can be displayed on the display device 7.

Moreover, the system has a charge controller 20 that can select any one of the grid power, generated power, and stored power as the electric power for charging of the traveling object 4; the charge controller 20 is connected to the display device 7, and can be operated via the display device 7; therefore, any one of the grid power, generated power, and stored power can be selected as the electric power for charging of the traveling object 4.

In addition, the operation mode, start time of charge, end time of charge, and priority of utilized power, etc., can be set for the charge controller 20 which can be operated and set on the operating screen of the display device 7; therefore, the storage battery of the traveling object 4 can be charged easily and effectively.

Moreover, the controller 22 connected to the thermal storage device 3 can be operated and set on the operating screen of the display device 7, which is to say, the operation mode, start time of power supply, end time of power supply, and priority of utilized power, etc., can be set on the operating screen of the display device 7; therefore, the power supply to the thermal storage device 3 can be controlled easily and effectively.

In addition, for the electric quantity bought from the system side, electric quantity sold to the system side, electric quantity generated by the solar electric power generation device 2, charge/discharge electric quantity of the electrical storage device 6, electric quantity consumed by the thermal storage device 3, electric quantity charged to the traveling object 4, and even the electric quantity consumed by the household electric loads 5, the balance, variation, and accumulative total (Accumulation) of power consumption, balance, variation, and accumulative total (Accumulation) of electricity fee, and balance, variation, and accumulative total (Accumulation) of emission amount of carbon dioxide can be stored as data on daily, monthly, and annual basis. Furthermore, the user can confirm the stored data as required.

The display device 7 has a suggestion display function for the ratio of actual value/target value of power consumption, ratio of actual value/target value of the emission amount of carbon dioxide, and ratio of actual value/target value of electricity fee; therefore, it can prompt the user for energy conservation.

In addition, as for the household electric power generation device that utilizes natural energy to generate electric power, this embodiment is described in an example of solar electric power generation device 2; however, a wind electric power generation device can be used as an alternate to the solar electric power generation device 2 for the household electric power generation device.

### Industrial Applicability

In the present invention, the electric quantity consumed by the household electric loads is detected by the third electric power detection device on the basis of grid power and generated power and displayed on the display device, the power consumption resulting from charging of the traveling object is detected by the fourth electric power detection device on the basis of grid power and generated power and displayed on the display device; hence, the electric quantity consumed by the household electric loads and the power consumption resulting from charging of the traveling object can be displayed on the basis of grid power and generated power respectively.

## Claims

1. An energy display system, comprising:
a first electric power detection device, which can detect the power consumption of external grid power;
a second electric power detection device, which can detect the power consumption of electric power generated by an in-house power generation device that is installed at the house side and utilizes natural energy to generate the electric power;
third electric power detection devices, which can detect the power consumption of household electric loads on the basis of the grid power and generated power respectively;
a fourth electric power detection device, which can detect the power consumption resulting from charging of a traveling object on the basis of the grid power and generated power respectively; and
a display device, which is connected with the first through fourth electric power detection devices, and can display the power consumption detected by the first, second, third, and fourth electric power detection devices.

2. The energy display system according to claim 1, wherein, the display device comprises carbon dioxide emission calculation devices, which can calculate an emission amount of carbon dioxide from generation of electric quantity equivalent to the power consumption of grid power detected by the first electric power detection device and can display the calculated emission amount of carbon dioxide.

3. The energy display system according to claim 2, wherein, the carbon dioxide emission calculation device can calculate an emission amount of carbon dioxide from generation of electric quantity equivalent to the power consumption of grid power resulting from the household electric loads and an emission amount of carbon dioxide from generation of electric quantity equivalent to the power consumption of grid power resulting from charging of the traveling object, respectively;
the display device can display the two types of calculated emission amount of carbon dioxide.

4. The energy display system according to claim 3, wherein, the carbon dioxide emission calculation device can calculate the accumulative total emission amount of carbon dioxide from generation of electric quantity equivalent to the power consumption of grid power resulting from charging of the traveling object;
the display device can display the calculated accumulative total emission amount of carbon dioxide.

5. The energy display system according to any one of claims 1-4, comprising:
an electricity fee calculation device, which can calculate the electricity fee caused by charging of the traveling object according to the power consumption of grid power resulting from charging of the traveling object; and
a travel distance calculation device, which can calculate the travel distance for which the traveling object can move according to the power consumption resulting from charging of the traveling object;
the display device can display the calculated electricity fee and travel distance.

6. The energy display system according to claim 5, wherein,
the electricity fee calculation device can calculate the accumulative total electricity fee caused by charging of the traveling object;
the travel distance calculation device can calculate the accumulative total travel distance of the traveling object;
the display device can display the calculated accumulative total electricity fee and accumulative total travel distance.

7. The energy display system according to any one of claims 1-6, comprising:
a charge controller, which can select the grid power or the electric power generated by the in-house electric power generation device as an electric power for charging of the traveling object;
the charge controller is connected to the display device, and can be operated via the display device.
